# EUROPÄISCHE PATENTSCHRIFT

(11) **EP 3 291 654 B1**
(45) Veröffentlichungstag und Bekanntmachung des Hinweises auf die Patenterteilung: **02.08.2023**
(21) Anmeldenummer: 17170345.7
(22) Anmeldetag: 10.05.2017
(51) Int. Cl.: H05K 1/02, H05K 5/00, H05K 1/11, H05K 3/32, H01R 12/71

(54) **STEUERMODUL FÜR EIN FAHRZEUG**
CONTROL MODULE FOR A VEHICLE
MODULE DE COMMANDE POUR UN VÉHICULE AUTOMOBILE

(30) Priorität: 29.08.2016 DE 102016216137
(43) Veröffentlichungstag der Anmeldung: 07.03.2018
(73) Patentinhaber: Robert Bosch GmbH, 70442 Stuttgart (DE)
(72) Erfinder: Zweigle, Peter, 71254 Ditzingen (DE)

(56) Entgegenhaltungen:
- DE-A1-102007 014 351
- DE-A1-102010 030 170
- US-B1- 6 334 782

## Beschreibung

### Gebiet der Erfindung

Die Erfindung betrifft eine Anordnung mit einem Aktuator und einem Steuermodul für ein Fahrzeug.

### Stand der Technik

Die elektrische Kontaktierung von Aktuatoren eines Automatikgetriebes zu deren Steuermodul ist häufig als Federkontaktpaar ausgeführt. Späne im Getriebeöl können zu Kurzschlüssen zwischen den beiden Federkontakten oder den zugehörigen Kontaktflächen bzw. zu nahe gelegenen Metallbauteilen führen. Um dies zu verhindern, ist der Kontaktbereich an den kritischen Seiten mit Schutzwänden umgeben, die üblicherweise am Aktuator angebracht sind. Wenn die Kontaktflächen direkt auf einer Leiterplattenoberfläche liegen, müssen in der Leiterplatte entsprechende Aussparungen vorgesehen werden, in die die Schutzwände eingesteckt werden, um die nötige Überlappungshöhe zu erreichen und eine Labyrinthwirkung zu erzielen.

Die Aussparungen in der Leiterplatte können dann unerwünscht sein, wenn auf der gegenüberliegenden Seite der Leiterplatte elektronische Komponenten bestückt sind, die mit der sogenannten Dam-and-Fill-Vergussmethode gegen Umwelteinflüsse geschützt werden. Beim Dam-and-Fill-Verfahren wird zunächst ein Damm aus einem hochviskosen Material um die elektronischen Komponenten erzeugt, und die entstehende Wanne wird mit einer wesentlich weniger viskosen Vergussmasse aufgefüllt.

Um zu verhindern, dass die dünnflüssige Vergussmasse in die Aussparung fließt, muss der Damm um diese herum gelegt werden, wodurch Bestückungsfläche verloren gehen kann.

Die DE 10 2010 030 170 A1 zeigt ein Steuergerät, bei dem auf einem Schaltungsträger ein Rahmen angeordnet ist, so dass sich eine Wanne bildet, die mit einer Moldmasse aufgefüllt wird.

Die DE 44 05 710 A1 zeigt eine Trägerplatte mit Bauelementen, die mit einem Ring umgeben werden, in den ein Gel gefüllt wird.

### Offenbarung der Erfindung

### Vorteile der Erfindung

Ausführungsformen der vorliegenden Erfindung können in vorteilhafter Weise ermöglichen, ein kompaktes, leicht herzustellendes und kostengünstiges Steuermodul mit gutem Spanschutz bereitzustellen.

Die Erfindung betrifft eine Anordnung mit einem Aktuator und einem Steuermodul für ein Gerät eines Fahrzeugs. Ein Steuermodul kann eine Leiterplatte mit elektronischen Komponenten zum Steuern des Geräts umfassen, das beispielsweise ein Getriebe bzw. ein Automatikgetriebe sein kann. Neben den elektronischen Komponenten, die eine Steuerschaltung bilden können, kann das Steuermodul elektrische Anschlüsse und/oder Sensoren umfassen.

Das Steuermodul kann an dem Gerät angebracht sein und auch mit diesem elektrisch verbunden sein. Das Fahrzeug kann ein Pkw, Lkw oder Bus sein.

Gemäß der Erfindung umfasst das Steuermodul eine Leiterplatte, die elektronische Komponenten zum Steuern wenigstens eines Aktuators trägt. Die Leiterplatte kann glasfaserverstärkten Kunststoff umfassen. Die elektronischen Komponenten können Widerstände, Kondensatoren, Halbleiterschaltelemente und/oder integrierte Schaltkreise umfassen. Der Aktuator kann einen Magneten umfassen, der beispielsweise mechanische Komponenten des Geräts bewegen kann.

Weiter umfasst das Steuermodul einen auf die Leiterplatte aufgetragenen Damm, der die elektronischen Komponenten umgibt, und eine Vergussmasse, in die die elektronischen Komponenten eingebettet sind und die innerhalb des Damms vergossen ist. Die elektronischen Komponenten können mit dem Dam-and-Fill-Verfahren eingegossen sein.

Außerdem umfasst das Steuermodul elektrische Kontaktflächen für den wenigstens einen Aktuator, wobei zwischen die elektrischen Kontaktflächen eine Trennwand aufgetragen ist. Die elektrischen Kontaktflächen können von Leiterbahnen der Leiterplatte bereitgestellt sein und/oder beispielsweise von der Leiterplatte bereitgestellte Kupferpads sein. Auf diese Kontaktflächen können Kontaktfedern des Aktuators abgesetzt werden, um einen elektrischen Kontakt herzustellen.

Zum Schutz vor Spänen, die die elektrischen Kontaktflächen und/oder die Kontaktfedern kurzschließen könnten, ist auf die Leiterplatte zwischen die Kontaktflächen, die einem Aktuator zugeordnet sind, eine Trennwand aufgetragen.

Die Trennwand kann genauso wie der Damm auf die Leiterplatte aufgetragen sein. Beispielsweise kann die Schutzwand aus einem Material hergestellt sein, dass bereits vor dem Aushärten seine Form nicht verliert und/oder an der Leiterplatte haften bleibt. Dieses Material kann genauso wie der Damm auf die Leiterplatte durch eine Düse gespritzt werden.

Damit sind keine neuen Prozessschritte zum Herstellen des Steuermoduls notwendig. Da die Aussparungen entfallen können, in die am Aktuator angebrachte Trennwände gesteckt werden, muss keine mechanische Schwächung der Leiterplatte erfolgen.

Gemäß der Erfindung sind die Trennwand und der Damm aus dem gleichen Kunststoffmaterial hergestellt. Beispielsweise können eine oder mehrere Trennwände als auch der Damm hergestellt werden, indem Kunststoffmaterial aus einer Düse auf die Leiterplatte gespritzt wird. Das Erzeugen der Trennwand und des Damms kann mit dem gleichen Werkzeug erfolgen. Es ist auch möglich, dass die Trennwand und der Damm gleichzeitig aushärten.

Gemäß einer Ausführungsform der Erfindung sind die Trennwand und/oder der Damm aus einem Kunststoffmaterial hergestellt, das vor dem Aushärten eine höhere Viskosität aufweist als das Vergussmaterial vor dem Aushärten. Das Kunststoffmaterial der Trennwand und des Damms kann bereits vor dem Aushärten seine Form beibehalten, d.h. nicht oder nur unwesentlich verfließen. Das Vergussmaterial kann relativ flüssig sein und in der durch den Damm und die Leiterplatte gebildeten Wanne verfließen.

Gemäß einer Ausführungsform der Erfindung sind die Trennwand und/oder der Damm raupenartig auf die Leiterplatte aufgetragen. Raupenartig kann dabei bedeuten, dass die Trennwand und der Damm längliche Abschnitte aufweisen, die einen (leicht) unregelmäßigen Querschnitt aufweisen können. Beispielsweise können die Trennwand und/oder der Damm durch Spritzen von Kunststoffmaterial aus einer Düse auf die Leiterplatte aufgebracht werden. Die Trennwand und/oder der Damm können wie Rippen von der Leiterplatte abstehen.

Gemäß einer Ausführungsform der Erfindung sind die Trennwand und der Damm miteinander verbunden. Es ist möglich, dass eine oder mehrere Trennwände und der Damm in einem Zug hergestellt werden. Der Damm kann auch als Abschnitt einer Trennwand dienen. Andererseits ist es aber auch möglich, dass eine oder mehrere Trennwände keine Verbindung zum Damm aufweisen.

Gemäß einer Ausführungsform der Erfindung sind die Trennwand und der Damm auf der gleichen Seite der Leiterplatte angeordnet. Damit können der Damm und die eine oder mehreren Trennwände auf einer Seite der Leiterplatte aufgetragen und anschließend das Innere des Damms mit Vergussmasse verfüllt werden, ohne dass die Leiterplatte gedreht werden muss.

Gemäß einer Ausführungsform der Erfindung sind die Trennwand oder eine weitere Trennwand und der Damm auf verschiedenen Seiten der Leiterplatte angeordnet. Damit kann der Damm relativ nahe am Rand der Leiterplatte geführt sein, wodurch Bestückungsfläche gewonnen werden kann. Wenn die elektronischen Komponenten und somit der Damm und die Vergussmasse auf einer anderen Seite als die eine oder mehreren Trennwände auf der Leiterplatte angebracht sind, kann zuerst die eine oder mehreren Trennwände auf die Leiterplatte aufgebracht werden. Danach kann die Leiterplatte umgedreht und der Damm und die Vergussmasse auf der anderen Seite aufgebracht werden. Die eventuell noch nicht ausgehärteten Trennwände können dabei aufgrund der hohen Viskosität ihres Materials so stabil sein, dass sie sich nicht oder nur unwesentlich verformen, auch wenn sie beispielsweise von der Leiterplatte nach unten abragen, wenn diese oben mit dem Damm und der Vergussmasse versehen wird. Die Aushärtung der Trennwände, des Damms und der Vergussmasse kann darauffolgend im selben Prozessschritt geschehen. Gemäß einer Ausführungsform der Erfindung sind auf die Leiterplatte auf beiden Seiten Dämme aufgetragen und ist innerhalb der Dämme Vergussmasse vergossen. Auch können auf der Leiterplatte auf beiden Seiten Trennwände aufgetragen sein. Die Leiterplatte kann auch auf beiden Seiten bestückt und mit dem Dam-and-Fill-Verfahren abgedeckt sein. Die Trennwände können auf beiden Seiten der Leiterplatte zusammen mit dem Damm der entsprechenden Seite aufgetragen werden.

Gemäß einer Ausführungsform der Erfindung verläuft die Trennwand zwischen zwei Kontaktflächen und seitlich entlang der Kontaktflächen. Die Trennwand kann dazu dienen, zwei benachbarte Kontaktflächen voneinander zu trennen und/oder eine Kontaktfläche von einem weiteren Potential abzutrennen. Beispielsweise kann eine Trennwand für jeweils zwei elektrische Kontaktflächen T-förmig geformt sein, wobei ein Fuß des Ts zwischen den beiden Kontaktflächen angeordnet ist.

Gemäß der Erfindung umfasst die Anordnung weiter einen Aktuator, der wenigstens zwei Kontaktfedern aufweist, die auf wenigstens zwei Kontaktflächen aufgepresst sind, so dass die Trennwand zumindest teilweise zwischen den Kontaktfedern verläuft, wobei der Aktuator Schutzwände aufweist, die die Kontaktfedern zumindest teilweise umgeben und die in Richtung der Leiterplatte weisen. Die Kontaktfedern des Aktuators können in einem Plastikelement aufgenommen sein, das in Richtung der Leiterplatte weist und die Kontaktfedern einzeln umgeben kann. Die Schutzwände des Aktuators verlaufen entlang, beispielsweise im Wesentlichen parallel, zu der Trennwand für die wenigstens zwei Kontaktflächen.

Auf diese Weise wird durch die Trennwand und eine Schutzwand ein Labyrinth gebildet. Die Spanschutzwirkung wird durch die Labyrinthwirkung zwischen der Trennwand auf der Leiterplatte und der Schutzwand am Aktuator verbessert. Die Abmessungen können so ausgelegt sein, dass die Toleranzkette zwischen den beispielsweise in einen Hydraulikblock eingebauten Aktuator und der Leiterplatte des Steuermoduls weder zu einer Kollision noch zu einem Verlust der Labyrinthwirkung führt. Mit anderen Worten kann zwischen der Schutzwand und der Leiterplatte ein Spalt vorhanden sein und/oder kann zwischen der Trennwand und dem Aktuator ein Spalt vorhanden sein.

Gemäß der Erfindung ist zwischen den Schutzwänden ein Kanal zur Aufnahme der Trennwand gebildet. Zwischen den Kontakten können sogar zwei Schutzwände und eine dazwischenliegende Trennwand vorhanden sein, wodurch die Labyrinthwirkung weiter verstärkt wird.

### Kurze Beschreibung der Zeichnungen

Nachfolgend werden Ausführungsformen der Erfindung unter Bezugnahme auf die beigefügten Zeichnungen beschrieben, wobei weder die Zeichnungen noch die Beschreibung als die Erfindung einschränkend auszulegen sind.
Fig. 1A zeigt eine perspektivische Ansicht eines Steuermoduls gemäß einer Ausführungsform der Erfindung.
Fig. 1B zeigt eine weitere perspektivische Ansicht des Steuermoduls aus der Fig. 1A.
Fig. 2 zeigt eine perspektivische Ansicht eines Steuermoduls gemäß einer weiteren Ausführungsform der Erfindung.
Fig. 3 zeigt eine perspektivische Ansicht eines Aktuators für ein Steuermodul gemäß einer Ausführungsform der Erfindung.
Fig. 4 zeigt eine perspektivische Ansicht eines Steuermoduls gemäß einer weiteren Ausführungsform der Erfindung.

Die Figuren sind lediglich schematisch und nicht maßstabsgetreu. Gleiche Bezugszeichen bezeichnen in den Figuren gleiche oder gleichwirkende Merkmale.

### Ausführungsformen der Erfindung

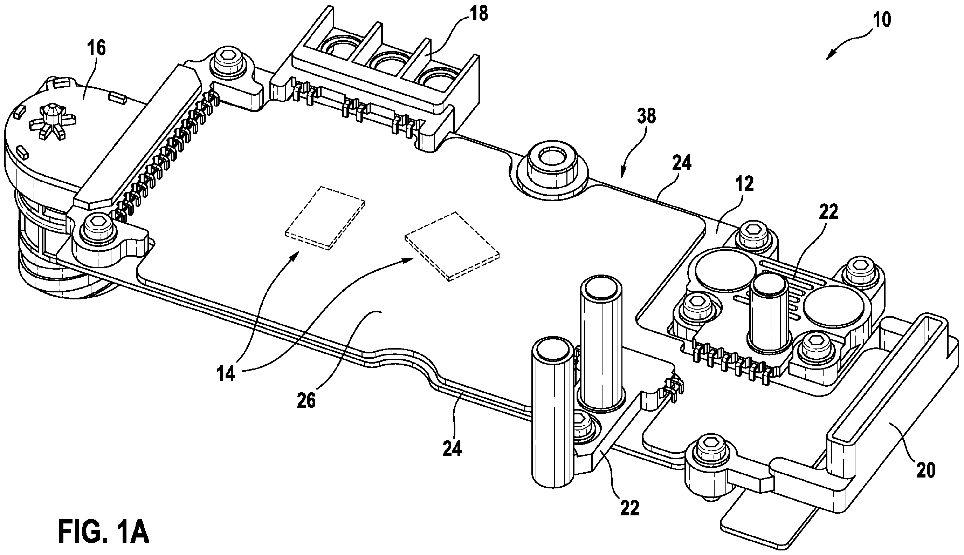

Fig. 1A zeigt ein Getriebesteuermodul 10, das eine Leiterplatte 12 und darauf befindliche elektronische Komponenten 14 umfasst. An der Leiterplatte 12 können noch weitere Komponenten des Steuermoduls 10 befestigt sein, wie etwa ein Leistungsanschluss 16, weitere Anschlüsse 18, eine Steckerleiste 20, Drucksensoren 22 usw.

Die elektronischen Komponenten 14 sind von einem Damm 24 umgeben, der abschnittsweise am Rand der Leiterplatte 12 verläuft, und der mit der Leiterplatte 12 zusammen eine Wanne bildet, in der die elektronischen Komponenten 14 in eine Vergussmasse 26 eingebettet sind.

Wie in der Fig. 1A zu erkennen ist, sind die elektronischen Komponenten 14 vollständig von der Vergussmasse 26 umgeben. Weiter ragen aus der Vergussmasse 26 Leiter hervor, die mit den Anschlüssen 16, 18, 20 und den Sensoren 22 verbunden sind.

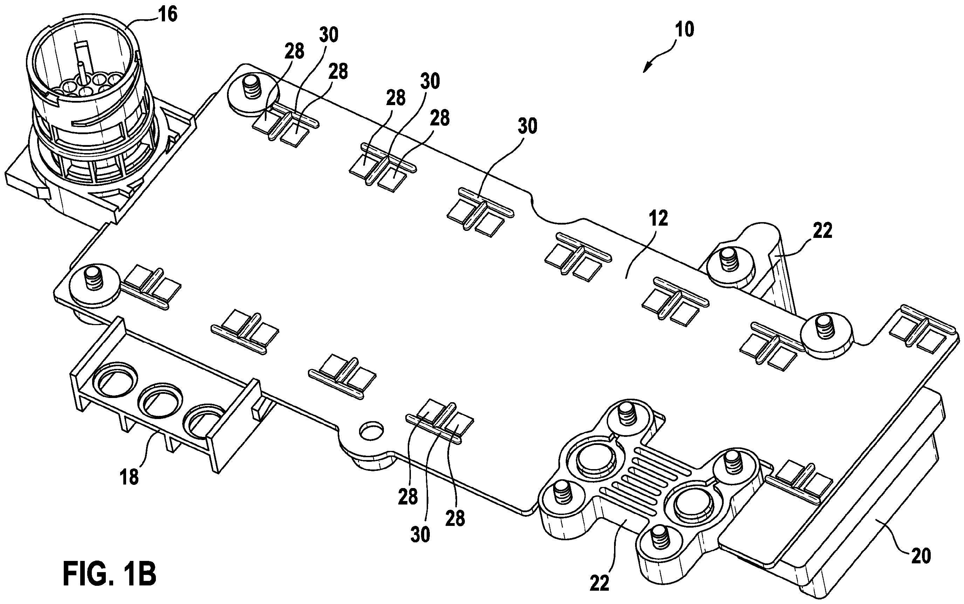

Die Fig. 1B zeigt das Steuermodul 10 aus der Fig. 1A von der anderen Seite. Auf der Seite, die der Seite mit dem Damm 24 und der Vergussmasse 26 gegenüberliegt, weist die Leiterplatte 12 Kontaktflächen 28 auf, die beispielsweise als Metallschicht auf der Leiterplatte 12 ausgebildet sein können. Jeweils zwei Kontaktflächen 28 bilden ein Paar von Anschlüssen für einen Aktuator, der von dem Steuermodul 10 angesteuert wird. Die Kontaktflächen 28 sind durch die Leiterplatte 12 hindurch mit den elektronischen Komponenten 14 elektrisch verbunden.

Zu jedem Paar von Kontaktflächen 28 ist auf der Leiterplatte 12 eine T-förmige Trennwand 30 angeordnet, die einen ersten Abschnitt aufweist, der zwischen den Kontaktflächen 28 verläuft und einen weiteren, zweiten Abschnitt aufweist, der neben den Kontaktflächen 28 verläuft. Der zweite Abschnitt kann dabei zum Rand der Leiterplatte 12 hin weisen.

Das Steuermodul 10 kann nun so hergestellt werden, dass die Leiterplatte 12, die bereits mit den elektronischen Komponenten 14 und optional mit den Anschlüssen 16, 18, 20 und/oder den Sensoren 22 bestückt wurde, zunächst mit den Trennwänden 30 versehen wird. Dazu kann beispielsweise mit einer Düse das nicht ausgehärtete Kunststoffmaterial der Trennwände 30 auf die in der Fig. 1B gezeigte Seite der Leiterplatte 12 in der Form der Trennwände 30 raupenförmig aufgetragen werden.

Danach kann die Leiterplatte 12 umgedreht werden und der Damm 24 auf die andere Seite aufgetragen werden, beispielsweise mit dem gleichen Werkzeug bzw. der oben genannten Düse. Anschließend kann die Vergussmasse 26 auf die Leiterplatte 12 gegossen werden, so dass sie innerhalb des Damms 24 verläuft und die Komponenten 14 einschließt.

Abschließend können die Trennwände 30, der Damm 24 und die Vergussmasse 26 ausgehärtet werden, beispielsweise in einem Ofen.

Der Damm 24 kann aus dem gleichen Kunststoffmaterial hergestellt sein wie die Trennwände 30. Das Kunststoffmaterial ist dabei derartig viskos, dass die Trennwände 30 auch im unausgehärteten Zustand an der Leiterplatte 12 haften bleiben und sich im Wesentlichen nicht verformen, auch wenn sie von der Leiterplatte 12 nach unten hängen.

Es ist auch möglich, dass die Trennwände 30 gehärtet werden, bevor der Damm 24 und die Vergussmasse 26 auf die Leiterplatte 12 aufgebracht werden.

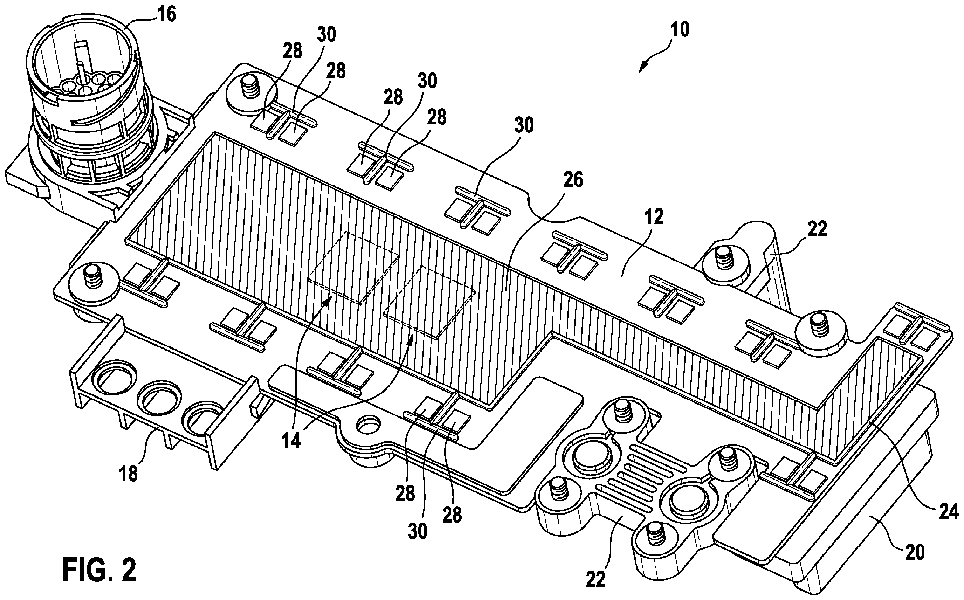

Die Fig. 2 zeigt eine weitere Ausführungsform eines Steuermoduls 10, bei dem die elektronischen Komponenten 14, der Damm 24, die Vergussmasse 26, die Kontaktflächen 28 und die Trennwände 30 auf der gleichen Seite der Leiterplatte 12 angeordnet sind. Dabei befinden sich die Kontaktflächen 28 und die Trennwände 30 außerhalb des Damms 24.

In diesem Fall ist es auch möglich, dass der Damm 24 und manche der Trennwände 30 miteinander verbunden sind. Es ist auch möglich, dass der Damm 24 einen Abschnitt einer Trennwand 30 bereitstellt.

Bei der Ausführungsform der Fig. 2 können der Damm 24 und die Trennwände im gleichen Prozessschritt hergestellt werden. Es ist auch möglich, dass auch die andere Seite der Leiterplatte 12 einen Damm 24 aufweist, innerhalb dem elektronische Komponenten 14 in Vergussmasse 26 eingegossen sind. Auch auf der anderen Seite können Trennwände 30 vorhanden sein.

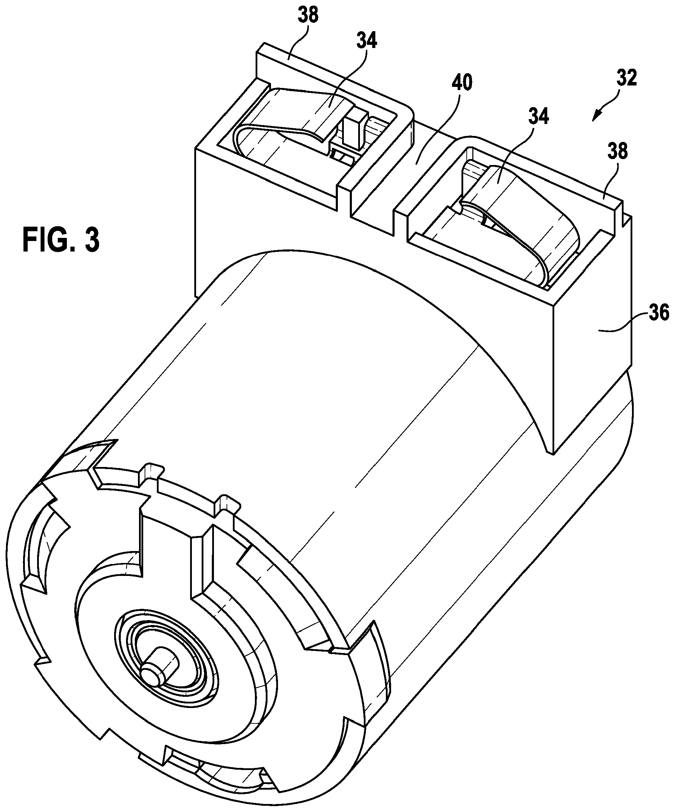

Die Fig. 3 zeigt einen Aktuator 32 für ein Steuermodul 10, der elektrisch mit dem Steuermodul 10 über die Kontaktflächen 28 verbunden wird. Dazu weist der Aktuator 32, beispielsweise ein Magnet, zwei Kontaktfedern 34 auf, die von dem Aktuator abstehen. Die Kontaktfedern 34 werden auf die Kontaktflächen 28 gepresst, wenn der Aktuator 32 über der Leiterplatte 12 platziert wird.

Jede der Kontaktfedern 34 ist von einem Gehäuseelement 36 umgeben, das die Kontaktfedern 34 kastenförmig umschließt. Auf dem Gehäuseelement 36 befinden sich zwei L-förmige Schutzwände 38, die abschnittsweise zwischen den Kontaktfedern 34 verlaufen. Die beiden L-förmigen Schutzwände 38 und das Gehäuseelement 36 bilden zwischen den Kontaktfedern 34 einen Kanal 40.

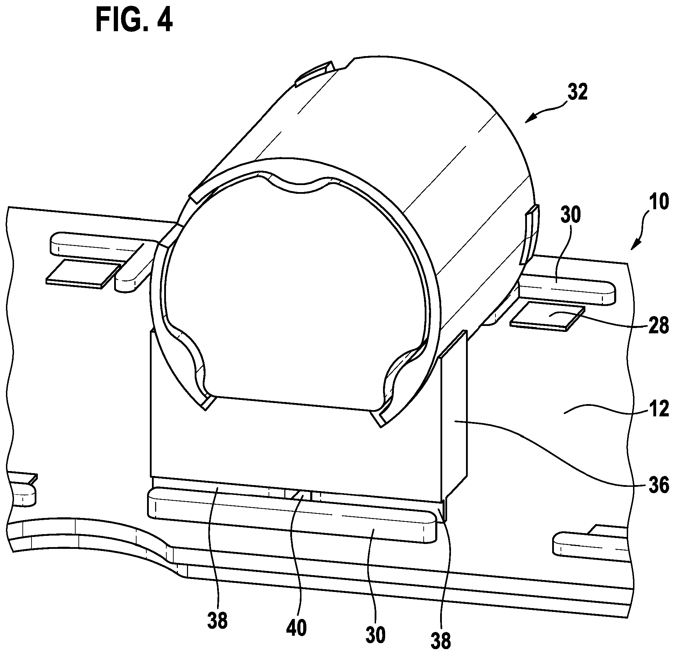

Die Fig. 4 zeigt den über der Leiterplatte 12 fixierten Aktuator 32. Die Schutzwände 38 berühren dabei nicht die Oberfläche der Leiterplatte 12. Genauso berührt die zugehörige Trennwand 30 nicht das Gehäuseelement 36 des Aktuators 32. Der Abschnitt der Trennwand 30, der zwischen den Kontaktflächen 28 verläuft, ist in dem Kanal 40 aufgenommen und bildet mit dem korrespondierenden Abschnitt der Schutzwände 38 ein Labyrinth, das eine Kontaktierung der Leiter unterhalb des Aktuators 32 miteinander durch Späne verhindert. Die Abschnitte der Trennwände 30, die neben den Kontaktflächen 28 verlaufen, verlaufen im Wesentlichen parallel zu weiteren Abschnitten der Schutzwände 38 und bilden ein weiteres Labyrinth, das verhindert, dass diese Leiter mit einem Leiter, beispielsweise neben dem Rand der Leiterplatte 12, durch Späne kontaktiert werden.

## Patentansprüche

1. Anordnung mit einem Aktuator (32) und einem Steuermodul (10) für ein Fahrzeug, das Steuermodul (10) umfassend:
eine Leiterplatte (12), die elektronische Komponenten (14) zum Steuern des Aktuators (32) trägt, einen auf die Leiterplatte (12) aufgetragenen Damm (24), der die elektronischen Komponenten (14) umgibt;
eine Vergussmasse (26), in die die elektronischen Komponenten (14) eingebettet sind und die innerhalb des Damms (24) vergossen ist;
elektrische Kontaktflächen (28) für den Aktuator (32); **dadurch gekennzeichnet, dass**
zwischen die elektrischen Kontaktflächen (28) eine Trennwand (30) auf die Leiterplatte (12) aufgetragen ist, wobei die Trennwand (30) und der Damm (24) aus dem gleichen Kunststoffmaterial hergestellt sind, wobei der Aktuator (32) wenigstens zwei Kontaktfedern (34) aufweist, die auf die wenigstens zwei Kontaktflächen (28) aufgepresst sind, so dass die Trennwand (30) zumindest teilweise zwischen den Kontaktfedern (34) verläuft, wobei der Aktuator (32) Schutzwände (38) aufweist, die die Kontaktfedern (34) zumindest teilweise umgeben und die in Richtung der Leiterplatte (12) weisen, wobei die Schutzwände (38) entlang der Trennwand (30) für die wenigstens zwei Kontaktflächen (28) verlaufen und wobei zwischen den Schutzwänden (38) ein Kanal (40) zur Aufnahme der Trennwand (30) gebildet ist.

2. Anordnung nach Anspruch 1,
wobei die Trennwand (30) und/oder der Damm (24) aus einem Kunststoffmaterial hergestellt sind, das vor dem Aushärten eine höhere Viskosität aufweist als die Vergussmasse (26) vor dem Aushärten.

3. Anordnung nach einem der vorhergehenden Ansprüche,
wobei die Trennwand (30) und der Damm (24) raupenartig auf die Leiterplatte (12) aufgetragen sind, wobei die Trennwand (30) und der Damm (24) längliche Abschnitte aufweisen, die einen unregelmäßigen Querschnitt aufweisen und als Rippen von der Leiterplatte (12) abstehen.

4. Anordnung nach einem der vorhergehenden Ansprüche,
wobei die Trennwand (30) und der Damm (24) miteinander verbunden sind.

5. Anordnung nach einem der vorhergehenden Ansprüche,
wobei die Trennwand (30) und der Damm (24) auf der gleichen Seite der Leiterplatte (12) angeordnet sind; und/oder
wobei die Trennwand (30) oder eine weitere Trennwand und der Damm (24) auf verschiedenen Seiten der Leiterplatte (12) angeordnet sind.

6. Anordnung nach einem der vorhergehenden Ansprüche,
wobei auf die Leiterplatte (12) auf beiden Seiten Dämme (24) aufgetragen sind und innerhalb der Dämme (24) Vergussmasse (26) vergossen ist; und/oder
wobei auf der Leiterplatte (12) auf beiden Seiten Trennwände (30) aufgetragen sind.

7. Anordnung nach einem der vorhergehenden Ansprüche,
wobei die Trennwand (30) zwischen zwei Kontaktflächen (28) und seitlich entlang der Kontaktflächen (28) verläuft;
wobei die Trennwand (30) für jeweils zwei elektrische Kontaktflächen (28) T-förmig geformt ist.

## Claims

1. Arrangement having an actuator (32) and a control module (10) for a vehicle, the control module (10) comprising:
a printed circuit board (12), which carries electronic components (14) for controlling the actuator (32),
a dam (24), which is applied to the printed circuit board (12) and which surrounds the electronic components (14);
a potting compound (26), in which the electronic components (14) are embedded and which is cast within the dam (24);
electric contact pads (28) for the actuator (32);
**characterized in that**
a partition (30) is applied to the printed circuit board (12) between the electric contact pads (28), wherein the partition (30) and the dam (24) are produced from the same plastics material, wherein the actuator (32) has at least two contact springs (34), which are pressed onto at least two contact pads (28), so that the partition (30) runs at least partly between the contact springs (34), wherein the actuator (32) has protective walls (38), which at least partly surround the contact springs (34) and which point in the direction of the printed circuit board (12), wherein the protective walls (38) run along the partition (30) for the at least two contact pads (28), and wherein a channel (40) for receiving the partition (30) is formed between the protective walls (38) .

2. Arrangement according to Claim 1,
wherein the partition (30) and/or the dam (24) are produced from a plastics material which has a higher viscosity before curing than the potting compound (26) before curing.

3. Arrangement according to one of the preceding claims,
wherein the partition (30) and the dam (24) are applied to the printed circuit board (12) in the manner of a bead, wherein the partition (30) and the dam (24) have elongated sections which have an irregular cross section and project from the printed circuit board (12) as ribs.

4. Arrangement according to one of the preceding claims,
wherein the partition (30) and the dam (24) are connected to each other.

5. Arrangement according to one of the preceding claims,
wherein the partition (30) and the dam (24) are arranged on the same side of the printed circuit board (12); and/or wherein the partition (30) or a further partition and the dam (24) are arranged on different sides of the printed circuit board (12).

6. Arrangement according to one of the preceding claims,
wherein dams (24) are applied to the printed circuit board (12) on both sides and potting compound (26) is cast within the dams (24); and/or
wherein partitions (30) are applied to the printed circuit board (12) on both sides.

7. Arrangement according to one of the preceding claims,
wherein the partition (30) runs between two contact pads (28) and laterally along the contact pads (28);
wherein the partition (30) is T-shaped for each two electric contact pads (28).

## Revendications

1. Agencement, comprenant un actionneur (32) et un module de commande (10) pour un véhicule, le module de commande (10) comprenant :
une carte de circuits imprimés (12) qui porte les composants électroniques (14) pour commander l'actionneur (32),
un barrage (24) appliqué sur la carte de circuits imprimés (12) et qui entoure les composants électroniques (14) ;
une masse de scellement (26) dans laquelle sont incorporés les composants électroniques (14) et qui est scellée à l'intérieur du barrage (24) ;
des surfaces de contact électriques (28) pour l'actionneur (32) :
**caractérisé en ce qu'**une paroi de séparation (30) est appliquée sur la carte de circuits imprimés (12) entre les surfaces de contact électriques (28), dans lequel la paroi de séparation (30) et le barrage (24) sont fabriqués à partir de la même matière plastique, dans lequel l'actionneur (32) présente au moins deux ressorts de contact (34) qui sont pressés sur les au moins deux surfaces de contact (28) de sorte que la paroi de séparation (30) s'étend au moins en partie entre les ressorts de contact (34), dans lequel l'actionneur (32) présente des parois de protection (38) qui entourent les ressorts de contact (34) au moins en partie et qui sont tournées en direction de la carte de circuits imprimés (12), dans lequel les parois de protection (38) s'étendent le long de la paroi de séparation (30) pour les au moins deux surfaces de contact (28), et dans lequel un canal (40) pour recevoir la paroi de séparation (30) est formé entre les parois de protection (38).

2. Agencement selon la revendication 1, dans lequel die paroi de séparation (30) et/ou le barrage (24) sont fabriqués à partir d'une matière plastique qui présente une viscosité plus élevée que la masse de scellement (26) avant le durcissement.

3. Agencement selon l'une quelconque des revendications précédentes, dans lequel la paroi de séparation (30) et le barrage (24) sont appliqués en forme de bourrelets sur la carte de circuits imprimés (12), dans lequel la paroi de séparation (30) et le barrage (24) présentent des sections allongées qui présentent une section transversale irrégulière et dépassent de la carte de circuits imprimés (12) sous forme d'ailettes.

4. Agencement selon l'une quelconque des revendications précédentes, dans lequel la paroi de séparation (30) et le barrage (24) sont reliés ensemble.

5. Agencement selon l'une quelconque des revendications précédentes,
dans lequel la paroi de séparation (30) et le barrage (24) sont disposés sur le même côté de la carte de circuits imprimés (12) ; et/ou
dans lequel la paroi de séparation (30) ou une autre paroi de séparation et le barrage (24) sont disposés sur différents côtés de la carte de circuits imprimés (12).

6. Agencement selon l'une quelconque des revendications précédentes,
dans lequel des barrages (24) sont appliqués sur la carte de circuits imprimés (12) des deux côtés et la masse de scellement (26) est scellée à l'intérieur des barrages (24) ; et/ou
dans lequel des parois de séparation (30) sont appliquées des deux côtés sur la carte de circuits imprimés (12).

7. Agencement selon l'une quelconque des revendications précédentes,
dans lequel la paroi de séparation (30) s'étend entre deux surfaces de contact (28) et s'étend latéralement le long des surfaces de contact (28) ;
dans lequel la paroi de séparation (30) est formée en forme de T pour respectivement deux surfaces de contact électriques (28).
